# EUROPEAN PATENT SPECIFICATION

(11) **EP 4 297 081 B1**
(45) Date of publication and mention of the grant of the patent: **12.08.2026**
(21) Application number: 23177548.7
(22) Date of filing: 06.06.2023
(51) Int. Cl.: H10W 90/00, H10W 70/20, H10W 70/60

(54) **POWER MODULE FOR HALF-BRIDGE CIRCUIT WITH SCALABLE ARCHITECTURE AND IMPROVED LAYOUT**
LEISTUNGSMODUL FÜR HALBBRÜCKENSCHALTUNG MIT SKALIERBARER ARCHITEKTUR UND VERBESSERTEM LAYOUT
MODULE DE PUISSANCE POUR CIRCUIT EN DEMI-PONT À ARCHITECTURE ÉVOLUTIVE ET TOPOLOGIE AMÉLIORÉE

(30) Priority: 22.06.2022 IT 202200013243
(43) Date of publication of application: 27.12.2023
(73) Proprietor: STMicroelectronics S.r.l., 20864 Agrate Brianza (MB) (IT)
(72) Inventor: SAVINO, Sergio, 95125 Catania (IT)
(74) Representative: Studio Torta S.p.A.

(56) References cited:
- WO-A1-2022/118633
- DE-A1- 102009 032 973
- US-A1- 2014 218 871
- US-A1- 2017 092 596

## Description

The present invention relates to a power module with scalable architecture and improved layout.

In particular, the present power module implements a half-bridge topology and is usable in inverters, rectifiers, static phase compensators, drive devices for electric motors in the automotive field, drive devices for electric transport means in general, industrial or household drive devices (for example in large "white" industrial apparatuses, in large household appliances such as washing machines and the like), and other applications.

The modules are normally enclosed in a packaging body of insulating material, such as molded epoxy resin, or made using the gel potted technique, wherein a plastic box is filled with an insulating gel and encloses the components. In both cases, the package has a generally parallelepiped shape, with two main (top and bottom) surfaces, and four side surfaces, of smaller area, having the leads for the electrical connection protruding therefrom. Other signal leads may also extend from the top surface.

The power modules with half-bridge topology comprise a plurality of (at least two) integrated electronic devices, arranged on a patterned metal and/or ceramic substrate. The substrate is generally connected and supported by a conductive mask called leadframe, obtained from a sheet of plane conductive material, which may also form the leads of the power module.

This entails a considerable layout complexity to avoid parasitic components, typically parasitic inductances, as well as requiring an accurate design to ensure clearance isolation distances ("clearance and creepage") and not allowing an efficient exploitation of the available spaces.

Furthermore, the overall dimensions of the power module cannot be reduced at will, due to the need of maintaining clearance distances.

Furthermore, it is not easy to modify and adapt the type of outer leads and their connection to the outer connection elements according to the specific design.

WO 2022/118633A discloses a power half-bridge module having a plurality of power devices fixed onto a support and electrically connected by terminals coupled to connection pads of the devices. The power devices are bonded on opposite faces to wiring layers extending on the support.

US 2014/218871 discloses a power module having terminals formed by clips that are partially superposed.

DE 10 2009 032973 and US 2017/092596 disclose other power devices.

The aim of the present invention is to provide a power module with a half-bridge topology which overcomes the drawbacks of the prior art.

According to the present invention, a power module is provided, as defined in the attached claims.

For a better understanding of the present invention, some embodiments thereof are now described, purely by way of non-limiting example, with reference to the attached drawings, wherein:
- Figure 1 is an equivalent electric diagram of a half-bridge circuit obtainable with the present power module;
- Figure 2 is a top view on an embodiment of the present power module, including four power devices enclosed in a package;
- Figure 3 is a bottom perspective view of the power module of Figure 2;
- Figure 4 is a top perspective view of the power module of Figure 2 without package;
- Figure 5 is a top-plan view of the power module of Figure 2 without package;
- Figure 6 is a top view of the power module of Figure 2 without package and without connection clips;
- Figure 7 is a top-plan view of the substrate of the power module of Figure 2 with dashed power devices;
- Figures 8-10 are top views of connection clips used in the power module of Figure 2;
- Figures 11A-11D show possible configurations of a portion of the substrate in case of a half-bridge circuit comprising one to eight power devices for each switch of the half-bridge circuit;
- Figures 12A and 12B are top views of other different configurations of the present power module characterized respectively by three devices and four electronic power devices for each switch of the half-bridge circuit;
- Figure 13 is a top view of yet another possible configuration of the present power module;
- Figure 14 is a top view of the substrate of the power module of Figure 13 with dashed power devices;
- Figure 15 is a top view of other connection clips used in the power module of Figure 2; and
- Figure 16 is a top view of further connection clips used in the power module of Figure 2.

The following description refers to the arrangement shown; consequently, expressions such as "above", "below", "top", "bottom", "right", "left" relate to the attached Figures and are not to be intended in a limiting manner.

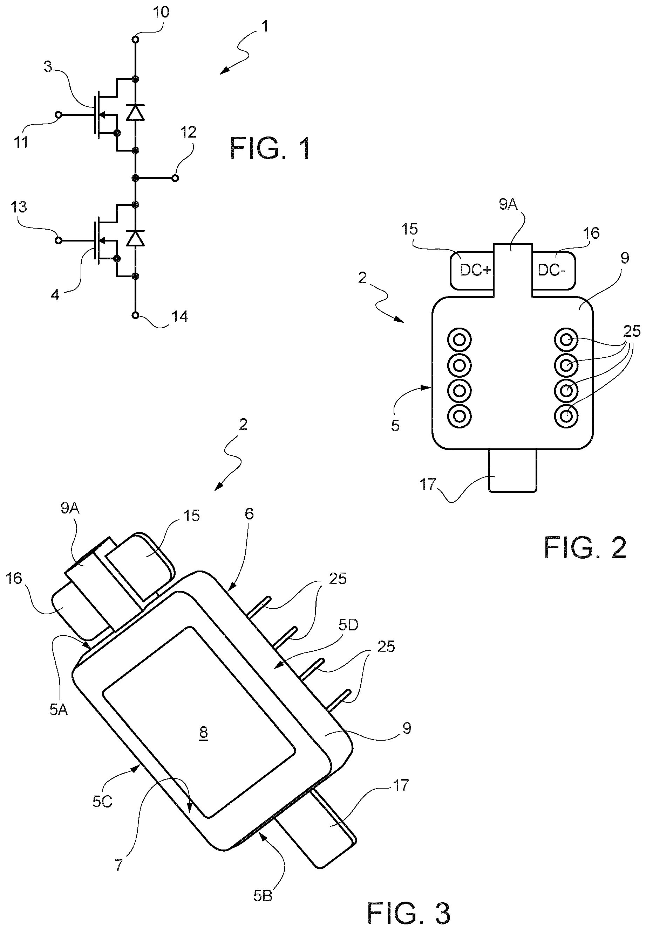

Figure 1 shows the electric diagram of a half-bridge circuit 1 implemented by a power module described below with reference to Figures 2-14.

The half-bridge circuit 1, of known type, comprises two power MOSFET transistors 3, 4 (also referred to as top transistor 3 and bottom transistor 4), here N-channel transistors, series-connected.

The top and bottom transistors 3, 4 may be of any type, for example charge-balanced transistors (also called "superjunction" transistors), silicon carbide vertical power MOSFET transistors, gallium nitride (GaN) planar power MOSFET transistors or other three-terminal (source, drain, gate) power devices.

The half-bridge circuit 1 has a first terminal 10, a second terminal 11, a third terminal 12, a fourth terminal 13 and a fifth terminal 14.

The first terminal 10 of the half-bridge circuit 1 is coupled to the drain terminal of the top transistor 3; the second terminal 11 of the half-bridge circuit 1 is coupled to the gate terminal of the top transistor 3; the third terminal 12 of the half-bridge circuit 1 is coupled to the source terminal of the top transistor 3 and to the drain terminal of the bottom transistor 4; the fourth terminal 13 of the half-bridge circuit 1 is coupled to the gate terminal of the bottom transistor 4; and the fifth terminal 14 is coupled to the source terminal of the bottom transistor 4.

Embodiments of the power module 2 implementing the half-bridge circuit 1 are shown in Figures 2-14 and described below.

In particular, Figures 2-10 show a first embodiment of the power module 2.

Here, the power module 2 comprises a package 9 of insulating material, such as resin, of generally parallelepiped shape, having four side surfaces 5, a first main surface 6 and a second main surface 7 (Figure 3).

The package 9 may be molded or made using a gel potted technique, wherein a plastic box is filled with an insulating gel, encloses the components, and has protruding leads.

Hereinafter, where useful for understanding, the side surfaces 5 are also referred to as first side surface 5A; second side surface 5B, opposite to the first side surface 5A, third side surface 5C, adjacent and contiguous to the first and the second side surfaces 5A, 5B; and fourth side surface 5D, opposite to the third side surface 5C.

In Figure 3, the second main surface 7 comprises a thermal dissipation region 8, for example a metal region embedded during molding of the package 7.

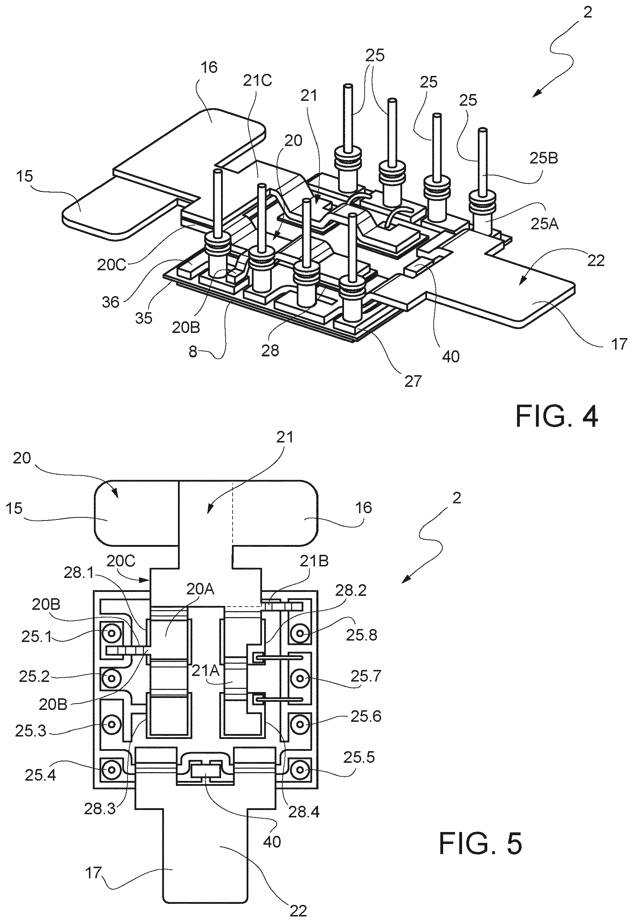

A first, a second and a third power pin 15-17 protrude here from two opposite side surfaces 5 and are part of three metal bands (hereinafter also referred to as first, second and third clips 20, 21, 22) which, in the embodiment of Figures 4-10, respectively couple the first terminal 10, the fifth terminal 14 and the third terminal 12 of the half-bridge circuit 1 of Figure 1 to the outside, as described in detail below.

In particular, here, the first and the second power pins 15, 16 protrude from the first side surface 5A and are generally intended to receive power supply potentials (DC+, DC-); the third power pin 17 protrudes from the second side surface 5B and is generally intended to be connected to a load (not shown).

The first terminal 10, the third terminal 12 and the fifth terminal 14 of the half-bridge circuit 1 of Figure 1 (as well as the second and the fourth terminals 11, 13) are coupled with the outside also through signal connections 25, as explained in detail below.

The power module 2 further comprises a substrate 27 having electronic power devices 28 attached thereto. The electronic power devices 28 may be soldered or sintered (powder sintering).

In the embodiment of Figures 4-10, the electronic power devices 28 are four, identified, where useful, as first, second, third and fourth devices 28.1, 28.2, 28.3 and 28.4.

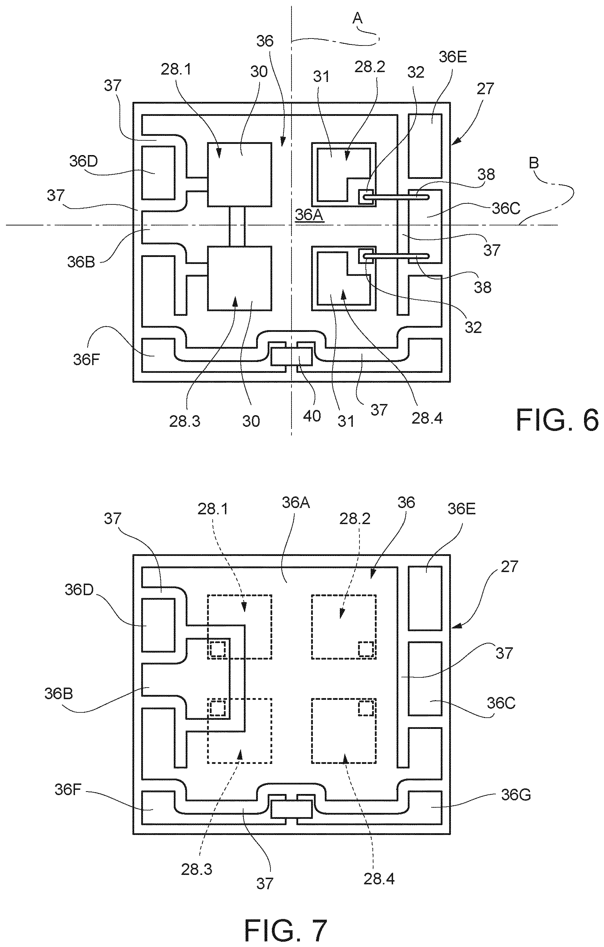

In detail, here the electronic power devices 28 are arranged side by side, two by two, as a regular matrix, and precisely, in the top view of Figure 6, the first and the third devices 28.1, 28.3 are arranged side by side on a left half of the substrate 27 and implement the top transistor 3; the second and the fourth devices 28.2, 28.4 are arranged on a right half of the substrate 27 and implement the bottom transistor 4.

The electronic power devices 28 are of a type having a drain pad 30 (forming a first conduction pad and visible in Figure 6 for the first and the third devices 28.1, 28.3) extending on a first main face; a source pad 31 (forming a second conduction pad and visible for the second and the fourth devices 28.2, 28.4) extending on a second main face, opposite to the first main face; and a gate pad 32 (forming a control pad and visible for the second and the fourth devices 28.2, 28.4), also extending on the second main face.

The gate pad 32 of each electronic power device 28 is arranged in proximity of one of the four corners of the respective device 28.

As evident from the above and shown with dashed lines in Figure 7, the electronic power devices 28 are arranged mutually flipped over around a median vertical axis (A in Figures 6 and 7) of the power module 2, that is the first and the third devices 28.1, 28.3 are arranged with the source and gate pads 31, 32 facing towards the substrate 27 and the drain pad 30 facing the opposite direction; the second and the fourth devices 28.2, 28.4 are arranged with the drain pad 30 facing towards the substrate 27 and the source and gate pads 31, 32 facing the opposite direction.

Furthermore, the electronic power devices 28 are arranged symmetrically with respect to a median horizontal axis (B in Figures 6 and 7) which separates the first from the third device 28.1, 28.3 (as well as the second from the fourth device 28.2, 28.4).

Here, the gate pads 32 of the two power devices 28 forming the top transistor 3 (28.1 and 28.3) or the bottom transistor 4 (28.2 and 28.4) face each other and are arranged close to the median horizontal axis B, facing towards the periphery of the substrate 27, for a simple connection thereof, as explained in detail below.

The substrate 27 functions as support and electrical connection of the electronic power devices 28 and is formed here by a multilayer, for example a DBC (Direct Bonded Copper) substrate or an AMB (Active Metal Brazing) substrate. For example, the substrate 27 (Figure 4) may comprise a first conductive layer, typically of a metal such as copper, forming the thermal dissipation region 8 and therefore indicated with the same reference number (Figures 3 and 4); an intermediate layer 35, which is insulating, for example of ceramic, superimposed on the thermal dissipation region 8; and a second conductive layer 36, typically of metal such as copper, superimposed on the intermediate layer 35.

The second conductive layer 36, whose layout is visible in Figures 6 and 7, is specifically patterned and forms a plurality of contact areas 36A-36G electrically insulated from each other by separation lines 37, for example obtained by removing the material of the second conductive layer 36 throughout its thickness.

In detail, the contact areas 36A-36G comprise here:
a main area 36A, approximately central, underlying (in part) and directly contacted by the source pads 31 of the first and the third devices 28.1, 28.3 and by the drain pads 30 of the second and the fourth devices 28.2, 28.4;
a first gate contact area 36B, underlying (in part) and directly contacted by the gate pads 32 of the first and the third devices 28.1, 28.3, as represented in Figure 7 by dashed lines;
a second gate contact area 36C, arranged peripherally and in proximity of the gate pads 32 of the second and the fourth devices 28.2, 28.4;
a drain contact area 36D arranged peripherally to the power module 2, laterally to one of the first and the third devices 28.1, 28.3 (in Figure 6, alongside the first device 28.1) and electrically coupled to the drain pad 30 of the first and the third devices 28.1, 28.3 through the first clip 20, as described in more detail below;
a source contact area 36E, arranged peripherally to the power module 2, laterally to one of the second and the fourth devices 28.2, 28.4 (in Figure 6, alongside the second device 28.2) and electrically coupled to the source pad 31 of the second and the fourth devices 28.2, 28.4 through the second clip 21, as described in more detail below; and
a first and a second thermal contact area 36F, 36G, arranged peripherally to the power module 2, here in proximity of the third and the fourth devices 28.3 and 28.4.

Conductive wires 38 extend between the gate pads 32 of the second and the fourth devices 28.2, 28.4 and the second gate contact area 36C, soldered at the ends.

As discussed below in detail and clearly visible in Figure 4, two side portions of the main area 36A and the contact areas 36B-36G are arranged in proximity of the periphery of the substrate 27, along the third and the fourth side surfaces 5C, 5D of the package 9 (Figure 3), and are coupled to the outside through the signal connections 25.

Returning to Figures 4, 5, as indicated, the first and the second clips 20, 21 extend on the electronic power devices 28 and contact them directly.

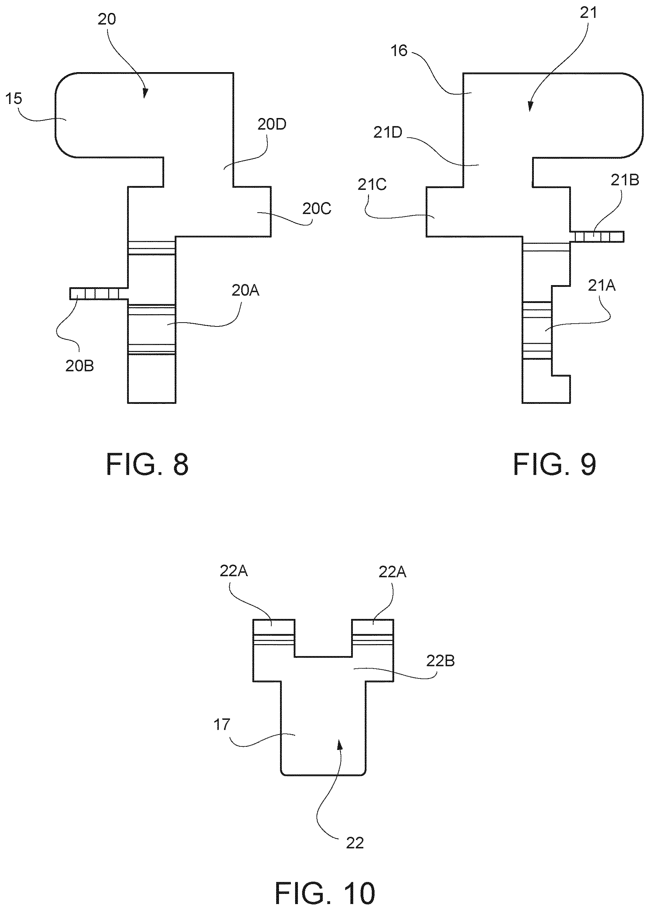

In detail, in the power module 2 shown here, the first clip 20 (see also Figure 8) has a substantially elongated shape having a main portion 20A.

The main portion 20A of the first clip 20 extends above and is in direct electrical contact with the drain pads 30 (Figure 6) of the first and the third devices 28.1, 28.3.

The first clip 20 also has a protrusion 20B extending transversely with respect to the main portion 20A, at the height of the drain contact area 36D (Figure 7), and is in direct electrical contact to the latter.

The first clip 20 has here a wing portion 20C extending transversely from one end of its own main portion 20A. The wing portion 20C of the first clip 20 is here arranged below and has the same shape as a corresponding wing portion of the second clip 21 (described below) and therefore is not visible in Figure 5.

A connecting portion 20D extends between the wing portion 20C of the first clip 20 and the first power pin 15.

The first clip 20 (see in particular Figure 4) has a three-dimensional shape which allows it to be in direct electrical contact with the drain pads 30 of the first and the third devices 28.1, 28.3 and with the drain contact area 36D (Figures 6, 7), maintaining a suitable distance from the second clip 21 and from the contact area 36A wherefrom it is electrically separated.

The second clip 21 (see also Figure 9) also has a substantially elongated shape having a respective main portion 21A extending laterally to the main portion 20A of the first clip 20.

The main portion 21A of the second clip 21 extends above and is in direct electrical contact with the source pads 31 (Figure 6) of the second and the fourth devices 28.2, 28.4.

The second clip 21 also has an own protrusion 21B extending transversely with respect to the respective main portion 21A, at the height of the source contact area 36E (Figure 7), and is in direct electrical contact with the latter.

As indicated above, the second clip 21 here has an own wing portion 21C, extending transversely with respect to the respective main portion 21A in proximity of the end thereof. As already mentioned, the wing portion 21C of the second clip 21 is here superimposed and congruent with the wing portion 20C of the first clip 20.A connecting portion 21D extends above the connecting portion 20D of the first clip 20, between its own wing portion 21C and the second power pin 16.

Furthermore, the power pins 15, 16 are also partially superimposed.

As noted from Figure 3, the superimposed portions of the first and the second power pins 15, 16 are enclosed by a protruding portion 9A of the package 9, which also extends between these superimposed portions, to ensure the electrical insulation thereof. Furthermore, in a non-visible manner, the material of the package 9 also extends between the wing portions 20C and 21C of the first and the second clips 20, 21, electrically insulating them from each other.

In other words, the first and second clips 20, 21, which are formed, as said, by metal bands, have main, mutually facing surfaces, formed here by the wing portions 20C, 21C, by the connecting portions 20D, 21D and by parts of the power pins 15, 16.

The superposed portions of the facing main surfaces of the first and second clips 20, 21 are thus capacitively coupled, with the insulating material of the package 9 forming an interposed dielectric, that counteracts and compensates any parasitic inductance of the power module 2.

Thus, the power module 2 has low communication losses, high electric efficiency and may operate at high switching frequency.

As noted in particular in Figure 4, also the second clip 21 has a three-dimensional shape which allows it to be in direct electrical contact with the source pads 31 of the second and the fourth devices 28.2, 28.4, bypassing the gate pads 32, and with the source contact area 36E (Figures 6, 7), maintaining a suitable distance from the first clip 20 and from the contact area 36A it is electrically separated from.

In practice, the first and the second clips 20, 21 shown in Figures 8 and 9 have a substantially symmetrical plan shape with respect to the median vertical axis A of the power module 2, (Figure 6), except for the protrusions 20B, 21B.

The third clip 22 (see also Figure 10) is here shorter than the first and the second clips 20, 21 and substantially comprises only two portions 22A in direct electrical contact with the main area 36A of the second conductive layer 36 and a transverse portion 22B which couples the portions 22A of the third clip 22 to the third power pin 17.

The clips 20-22 may be sintered or soldered to both the electronic power devices 28 and the contact areas 36A, 36D and 36E.

By virtue of the arrangement of the first and second clips 20, 21 to directly contact opposite surfaces of the first device 28.1 and of the second device 28.2 (as well as, in case, of third device 28.3 and of fourth device 28.4), the main area 36A may be a single region, which is very advantageous. In fact, the layout is advantageous from the thermal point of view (no side effects, smaller heat concentration at the edges, better dissipation between adjacent areas); for dimensions (the layout is smaller); and electrically (lower inductances thanks to the smaller dimensions).

Obviously, the exact geometric shapes of the clips 20-21 may differ widely from what is shown, provided that they allow the electrical connections described above.

For example, the first and the second clips 20, 21 superimpose, at least partially, also at most of the main portions 20A, 21A.

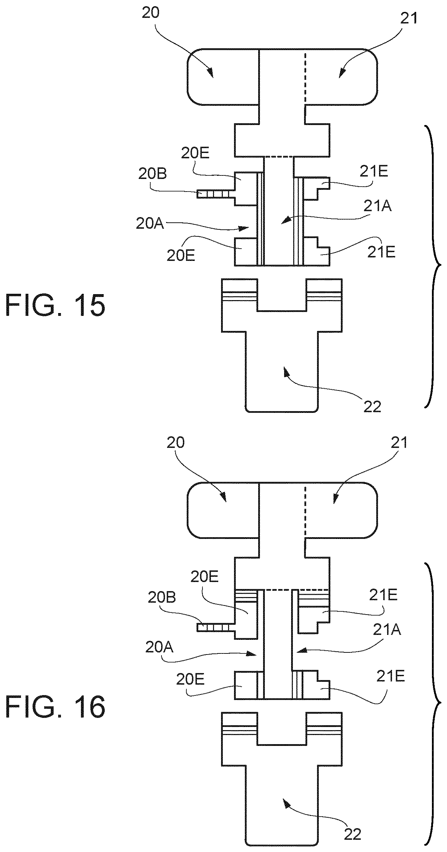

For example, Figures 15 and 16 show clips 20, 21 having main portions 20A, 21A extending along the vertical centerline of the substrate 27 (along the median vertical axis A of Figure 6). They also have protruding portions 20E, 21E for contacting the pads of the electronic power devices 28, according to the above.

Alternatively, only one of the main portions 20A, 21A may extend centrally, along the median vertical axis A of Figure 6.

According to an alternative configuration, the protrusions 20B and/or 21B may extend at least in part parallel or according to different angles with respect to the respective main portions 20A, 21A, as shown in Figure 16.

As is evident to the person skilled in the art, the above however represents only some of the countless variants of shape and configuration of the clips 20-22.

Similar considerations also apply to the contact areas 36A-36G, whose shape and position may vary considerably with respect to what has been described and illustrated, also in combination with the shape and arrangement of the clips 20-22.

The signal connections 25 may be made as described in Italian patent application IT202200006617A filed on April 4, 2022 in the name of the Applicant and entitled "Power module having leadframe-less signal connectors, in particular for automotive applications, and assembling method thereof".

In particular, Figure 4, the signal connections 25 are here each formed by a pillar portion 25A, attached directly to the contact areas 36A-36G of the second conductive layer 36 and ending approximately level with the top surface 6 of the package 9, and by an outer portion 25B, protruding from the package 9 in continuation with the pillar portion 25A (Figure 3).

The pillar portion 25A may be attached to the contact areas 36A-36G by soldering, with or without filler material (soldering, welding and sintering), or with a conductive glue.

The outer portion 25B is a signal pin and may be both monolithic with the pillar portion 25A and soldered or fitted thereto, and may have a different shape according to the considered type of connection.

Eight signal connections 25 are provided in the power module 2 of Figures 2-10, namely (Figure 5):
- a first signal connection 25.1, attached to the drain contact area 36D and then coupled with the drain pads 30 of the first and the third devices 28.1, 28.3 through the protrusion 20B of the first clip 20;
- a second signal connection 25.2, attached to the first gate contact area 36B and coupled by the latter to the gate pads 32 of the first and the third devices 28.1, 28.3, to provide first switching signals of the half-bridge circuit 1 of Figure 1;
- a third signal connection 25.3, attached to a peripheral portion of the main area 36A and then coupled to the source pads 31 of the first and the third devices 28.1, 28.3 and to the drain pads 30 of the second and the fourth devices 28.2, 28.4;
- a fourth signal connection 25.4, attached to the first thermal contact area 36F;
- a fifth signal connection 25.5, attached to the second thermal contact area 36G;
- a sixth signal connection 25.6, attached to another peripheral portion of the main area 36A opposite the third signal connection 25.3 and coupled as the latter;
- a seventh signal connection 25.7, attached to the second gate contact area 36C and coupled to the gate pads 32 of the second and the fourth devices 28.2, 28.4 through the conductive wires 38, to provide second switching signals of the half-bridge circuit 1 of Figure 1; and
- an eighth signal connection 25.8, attached to the source contact area 36E and coupled to the source pads 31 of the second and the fourth devices 28.2, 28.4 through the protrusion 21B of the second clip 21.

The signal connections 25.2, 25.3, 25.6 and 25.8 represent additional connections with respect to the power pins 15-17 and are useful for controlling the power module 2 during its operation.

A temperature sensor 40 is here attached to the substrate 27. For example, the temperature sensor 40 is of NTC type with SMD package and is attached to the sixth and the seventh signal connections 25.6, 25.7 through the first and the second thermal contact areas 36F, 36G.

The power module 2 may be adapted to half-bridge circuits formed by a different number of electronic power devices 28, with a simple adaptation of the layout of the second conductive layer 36 and of the clips 20-21.

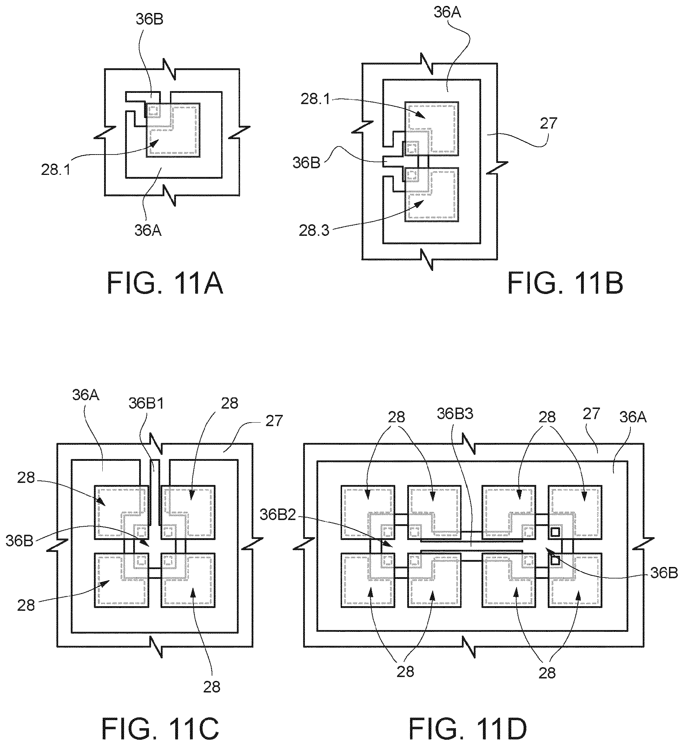

For example, Figures 11A-11D show possible layouts of the portion of the top transistor 3 of Figure 1, in case of implementation by one, two, four and eight electronic power devices 28. The corresponding layout of the portion of the bottom transistor 4 of the half-bridge circuit 1 of Figure 1 may be obtained by analogy to Figures 4-7.

Figure 11A relates to the implementation of the top transistor 3 of Figure 1 by a single electronic power device 28. This arrangement does not substantially differ from the configuration of half of the first gate contact area 36B (as regards the third device 28.3), as shown in Figure 7. The various regions have therefore been indicated with the same reference numbers. In particular, here, the first gate contact area 36B is L-shaped.

Figure 11B relates to the implementation of the top transistor 3 of Figure 1 by two electronic power devices 28. This arrangement substantially corresponds to the configuration of the first gate contact area 36B of Figure 7 and refers, in particular, to the first and the third devices 28.1, 28.3. The various regions have therefore been indicated with the same reference numbers. In particular, here, the first gate contact area 36B is T-shaped.

Figure 11C relates to the implementation of the top transistor 3 of Figure 1 by four electronic power devices 28. This arrangement results approximately from doubling the structure of Figure 11B, after rotation by 90° and flipping over, except for the branch of the first gate contact area 36B, which is now formed by a square, central area and by a shank 36B1 joining it with the periphery of the substrate 37. However, for clarity of illustration, the various regions have again been indicated with the same reference numbers.

Figure 11D relates to the implementation of the top transistor 3 of Figure 1 by eight electronic power devices 28. This arrangement results approximately from doubling the structure of Figure 11C, after rotation by 90° and flipping over, and the first gate contact area 36B now comprises two central areas 36B2, square-shaped, joined by a connection section 36B3. The first gate contact area 36B may be coupled with the periphery of the substrate 37 by wire or clip or be directly connected to the outside through a signal connection similar to the signal connections 25 of Figure 4.

For the rest, also here, the various regions have still been indicated with the same reference numbers.

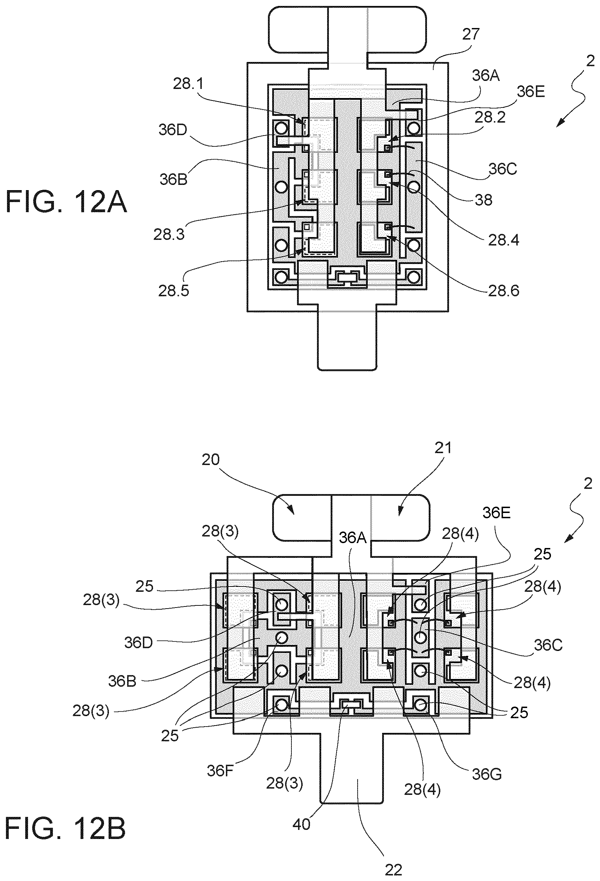

Figure 12A shows a possible configuration of the power module 2 when each power MOSFET transistor 2, 3 of the half-bridge circuit 1 of Figure 1 is formed by three power devices 28.

In Figure 12A, for ease of understanding, the same reference numbers of Figures 2-10 have been used; the further power devices 28 with respect to the previous figures are indicated here as fifth device 28.5 (forming part of the top transistor 3) and sixth device 28.6 (forming part of the bottom transistor 4).

The fifth and the sixth devices 28.5, 28.6 are here arranged adjacent and oriented like the second and the fourth devices 28.3, 28.4, respectively.

Furthermore, here, the three devices 28.1, 28.3, 28.5 forming the top transistor 3 of the half-bridge circuit 1 of Figure 1 are arranged aligned to each other, in a first half (on the left in Figure 12A) and the three devices 28.2, 28.4, 28.6 forming the bottom transistor 4 of the half-bridge circuit 1 of Figure 1 are arranged aligned to each other, in a second half (on the right in Figure 12A).

Furthermore, the first gate contact area 36B has a further branch for connecting the gate pad 32 (visible in ghost in Figure 12A) of the fifth device 28.5; the shape of the contact areas 36 and of the clips 20-22 is slightly modified to allow contacting the fifth and the sixth devices 28.5, 28.6, in a manner easily deducible by the person skilled in the art.

Figure 12B shows a possible configuration of the power module 2 when each power MOSFET transistor 2, 3 of the half-bridge circuit 1 of Figure 1 is formed by four power devices 28, also indicated as power devices 28(3) when referred to the top transistor 3 of the half-bridge circuit 1 of Figure 1 and power devices 28(4) when referred to the bottom transistor 4.

The four devices 28(3), 28(4) of each power MOSFET transistor 3, 4 (Figure 1) are arranged substantially as shown in Figure 11C, except for the first gate contact area 36B, similar to that, doubled and flipped over, of Figure 11B and arranged centrally to the group of four devices 28(3) forming the top transistor 3 of the half-bridge circuit 1 of Figure 1.

The second gate contact area 36C, on the other hand, is of any shape, for example rectangular, arranged here centrally to the group of four devices 28(4) forming the bottom transistor 4 of the half-bridge circuit 1 of Figure 1.

Furthermore, here, the signal connections 25 are arranged centrally with respect to each group of four devices 28, and no longer in proximity of the side surfaces 5C, 5D of the substrate 27, as in Figures 2-12A.

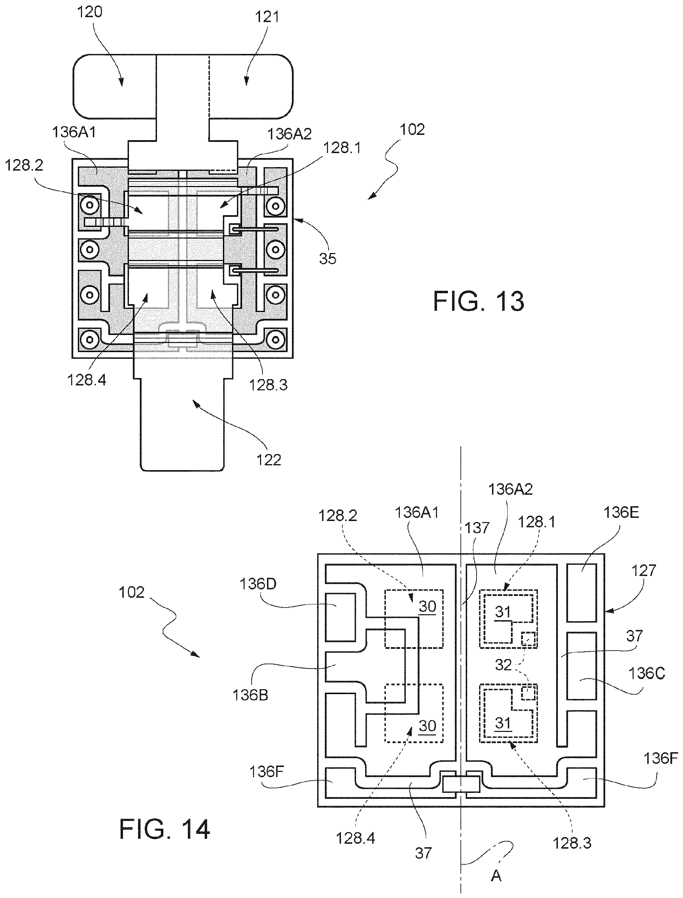

Figures 13 and 14 show another embodiment of the power module (here indicated by 102) wherein the position of the power MOSFET transistors is inverted with respect to Figures 4-12B. Consequently, in Figures 13 and 14, like parts to those of Figures 4-12B are indicated by reference numbers increased by 100.

Here, the first and the third devices (indicated as 128.1, 128.3 and forming the top transistor 3 of the half-bridge circuit 1 of Figure 1) are arranged in the right half of Figures 13, 14 and the second and the fourth devices (indicated as 128.2, 128.4 and forming the bottom transistor 4 of the half-bridge circuit 1 of Figure 1) are arranged in the left half of Figures 13, 14.

In this case, the main area 36A of Figures 4-7 is divided into two parts (first and second half-areas 136A1, 136A2) respectively to the right and to the left of the median vertical axis A in Figures 13, 14.

Therefore, in the power module 102, the first and the third devices 128.1, 128.3 are attached to the first half-area 136A1 with their own first main face having the drain pad 30; the second and the fourth devices 128.2, 128.4 are attached to the second half-area 136A2 with their own second main face having the source 31 and gate 32 pads.

Furthermore, here, the first clip (indicated by 120) is shorter and is attached to the second half-area 136A2 in proximity of the first side surface 5A of the package 9 (Figure 3); the second clip (indicated by 121) is also shorter and is attached to the first half-area 136A1, also in proximity of the first side surface 5A of the package 9 (Figure 14); the third clip (indicated by 122) is longer with respect to Figures 4-9 and has a substantially elongated shape which extends above and is in direct electrical contact with the source pads 31 (Figure 14) of the first and the third devices 28.1, 28.3 and with the drain pads 30 of the second and the fourth devices 28.2, 28.4.

Here, the first and the second clips 120, 121 may have an exactly symmetrical plan shape with respect to the median vertical axis A (Figure 14).

For the rest, the power module 102 may be provided in a manner that is entirely similar to the power module 2; in particular, the layout of the contact areas (indicated here as 136B-136G, in addition to 136A1, 136A2) may have any shape among those shown in Figures 7, 11A-12B, also depending on the number of electronic power devices 128 which form the power MOSFET transistors 3, 4.

The power module described herein has many advantages.

In particular, the second conductive layer 36 of the substrate 27 has a very simple layout, which allows a symmetrical arrangement of the electronic power devices 28, without connections crossing each other, with short gate, source and drain connection paths, thus reducing dimensions and parasitic inductances. It has a low shape factor, which allows for high power density, providing a high reliability of electrical connections.

In this manner, the present power module has a size comparable to the size currently obtainable for half-bridge circuits wherein each power MOSFET transistor 2, 3 is formed by a single electronic power device 28.

The same substrate 27 may be used for electronic power devices 28 of different dimensions, providing a high scalability, maintaining the pin-out configuration, thus allowing plug-and-play applications of modules of a same family.

In particular, the present module allows both a vertical scalability, as shown in Figure 12A, and a horizontal scalability, as shown in Figure 12B.

The described power module 2, 102 allows a reduction of the bonding wires or their complete elimination, if the conductive wires 38 are replaced by small clips soldered between the gate pads 32 and the second gate contact area 36C.

Furthermore, it allows for symmetrical current paths for the top and bottom transistors 2, 3, thereby equalizing the switching speed of the electronic power devices 28. Last but not least, the present power module has a short and simple bill of materials (BOM) and may therefore be manufactured at low cost.

Furthermore, the layout of the connections and clips may be easily adapted to any number of electronic power devices 28 forming the power MOSFET transistors 2, 3.

The shape of the signal connections 25 may vary, in particular standard pins may be used.

The present power module may be coupled to either single-side or dual-side cooling systems.

The half-bridge structure may be doubled or tripled, if two or more phases are desired.

## Claims

1. A power module (2), comprising:
a support (35);
a first control contact area (36B; 136C) on the support;
a second control contact area (36C; 136B) on the support;
a first electronic power device (28.1; 128.1) having a first main face and a second main face, a first conduction pad (30) on the first main face, a second conduction pad (31) on the second main face and a control pad (32) on the second main face;
a second electronic power device (28.2; 128.2) having a first main face and a second main face, a first conduction pad (30) on the first main face, a second conduction pad (31) on the second main face and a control pad (32) on the second main face;
a first clip (20; 121);
a second clip (21; 120);
a third clip (22; 122); and
a package (9) embedding the support, the first and the second electronic power devices as well as partially the first, the second and the third clips,
wherein the first electronic power device (28.1; 128.1) has the first conduction pad (30) electrically coupled to the first clip (20; 121); the second conduction pad (31) electrically coupled to the third clip (22; 122) and the control pad (32) coupled to the first control contact area (36B; 136C);
the second electronic power device (28.2; 128.2) has the first conduction pad (30) electrically coupled to the third clip (22; 122), the second conduction pad (31) electrically coupled to the second clip (21; 120), and the control pad (32) coupled to the second control contact area (36C; 136B);
the first and the second electronic power devices form a half-bridge circuit (1);
the first and the second clips (20, 21; 121, 120) forming respective power pins (15, 16), protruding from a first side (5A) of the package (9) and the third clip (22; 122) having a respective power pin (17), protruding from a second side (5B) of the package (9), opposite to the first side (5A);
the first and the second clips (20, 21; 121; 120) are formed by metal bands having respective main extension surfaces,
**characterized in that** the main extension surfaces of the first and the second clips (20, 21; 121; 120) are mutually superimposed at facing portions (20C, 21C, 20D, 21D, 15, 16) that are electrically insulated from each other by the package (9),
the facing portions including parts of the power pins (15, 16) of the first and the second clips, and
the package having a protruding portion (9A) enclosing the facing portions of the power pins (15, 16) of the first and the second clips (20, 21; 121; 120) protruding from the first side (5A) of the package (9), the package (9) extending also between the facing portions of the first and the second clips (20, 21; 121; 120).

2. The power module according to the preceding claim, wherein the first electronic power device (28.1; 128.1) is flipped over with respect to the second electronic power device (28.2; 128.2) around a support median axis (A) extending between the first and the second electronic power devices.

3. The power module according to claim 1 or 2, further comprising a third electronic power device (28.3; 128.3) and a fourth electronic power device (28.4; 128.4),
the third electronic power device (28.3; 128.3) having a first main face and a second main face, a first conduction pad (30) on the first main face, a second conduction pad (31) on the second main face and a control pad (32) on the second main face;
the fourth electronic power device (28.4; 128.4) having a first main face and a second main face, a first conduction pad (30) on the first main face, a second conduction pad (31) on the second main face and a control pad (32) on the second main face;
the third electronic power device (28.3; 128.3) having the second conduction pad (31) electrically coupled to the third clip (22; 122), the first conduction pad (30) electrically coupled to the first clip (20; 121) and the control pad coupled to the first control contact area (36B; 136C);
the fourth electronic power device (28.4; 128.4) having the first conduction pad (30) electrically coupled to the third clip (22; 122), the second conduction pad (31) electrically coupled to the second clip (21; 120), and the control pad (32) coupled to the second control contact area (36C; 136B).

4. The power module according to the preceding claim when dependent on claim 2, wherein the third electronic power device (28.3; 128.3) is flipped over with respect to the fourth electronic power device (28.4; 128.4) around the support median axis (A).

5. The power module according to any of the preceding claims, further comprising a metal electrical conductor (38) coupling the control pad (32) of the second electronic power device (28.2) to the second control contact area (36C).

6. The power module according to any of claims 1-4, further comprising a metal electrical conductor (38) coupling the control pad (32) of the first electronic power device (128.1) to the first control contact area (136C).

7. The power module according to any of the preceding claims, wherein the facing portions (20C, 21C, 20D, 21D, 15, 16) form capacitive elements.

8. The power module according to any of the preceding claims, further comprising:
a first gate connection element (25.2) coupled to the first control contact area (36B); and
a second gate connection element (25.7) coupled to the second control contact area (36C);
the first and the second gate connection elements (25.2, 25.7) extending transversely to a main face of the support (35) and having a respective end portion (25B) protruding from a main surface (6) of the package (9).

9. The power module according to the preceding claim, wherein the first and the second sides of the package extend transversely to the main surface (6) of the package (9).

10. The power module according to any of the preceding claims, further comprising a phase contact area (36A) extending on the support (35) and electrically coupled to the third clip;
wherein the first electronic power device (28.1) has the second main face facing towards the support and the second conduction pad (31) electrically coupled to the phase contact area;
the second electronic power device (28.2) has the first main face facing towards the support, the first conduction pad (30) electrically coupled to the phase contact area;
the first clip (20) overlies the first main face of the first electronic power device (28.1) and is coupled to the first conduction pad (30) of the first electronic power device, and
the second clip (21) overlies the second main face of the second electronic power device (28.2) and is coupled to the second conduction pad (31) of the second electronic power device.

11. The power module according to any of claims 1-9, further comprising:
a first conduction contact area (136A) on the support (35) electrically coupled to the first clip (121); and
a second conduction contact area (136B) on the support (35) electrically coupled to the second clip (120);
wherein the first electronic power device (128.1) has the first main face facing towards the support and the first conduction pad (30) is electrically coupled to the first conduction contact area (136A);
the second electronic power device (128.2) has the second main face facing towards the support (35) and the second conduction pad (31) is electrically coupled to the second conduction contact area (136B);
the third clip (122) faces the second main face of the first electronic power device (128.1) and the first main face of the second electronic power device (128.2) and is coupled to the second conduction pad (31) of the first electronic power device and to the first conduction pad (30) of the second electronic power device (128.2).

12. The power module according to any of the preceding claims when dependent on claim 10, further comprising:
a first auxiliary connection element (25.1), coupled to the first clip (20) through a first auxiliary contact area (36D) on the support (35);
a second auxiliary connection element (25.8), coupled to the second clip (21) through a second auxiliary contact area (36E) on the support (35); and
a third auxiliary connection element (25.3, 25.6), coupled to the third clip (22) through the phase contact area (36A) on the support (35),
the first, second and third auxiliary connection elements extending transversely to the support (35) and having a respective portion protruding from a main surface (6) of the package (9).

13. The power module according to any of the preceding claims, wherein the support (35), the first control contact area (36B; 136C) and the second control contact area (36C; 136B) are part of a multilayer substrate (27) including a first conductive layer (36) forming the first control contact area (36B) and the second control contact area (36C), a second conductive layer (8) forming a thermally dissipative element facing an outer surface of the power module (2) and an insulating layer (35) interposed between the first and the second conductive layers and forming the support (35).

14. The power module according to any of the preceding claims, wherein the first and the second electronic power devices (128.1, 128.2) are power MOSFETs.

15. The power module according to any of the preceding claims, wherein the first, the second and the third clips (20, 21; 121; 120; 22; 122) are monolithic.

## Patentansprüche

1. Leistungsmodul (2), umfassend:
einen Träger (35);
einen ersten Steuerkontaktbereich (36B; 136C) auf dem Träger;
einen zweiten Steuerkontaktbereich (36C; 136B) auf dem Träger;
eine erste elektronische Leistungsvorrichtung (28.1; 128.1) mit einer ersten Hauptfläche und einer zweiten Hauptfläche,
einem ersten Leitpad (30) auf der ersten Hauptfläche, einem zweiten Leitpad (31) auf der zweiten Hauptfläche und einem Steuerpad (32) auf der zweiten Hauptfläche;
eine zweite elektronische Leistungsvorrichtung (28.2; 128.2) mit einer ersten Hauptfläche und einer zweiten Hauptfläche, einem ersten Leitpad (30) auf der ersten Hauptfläche, einem zweiten Leitpad (31) auf der zweiten Hauptfläche und einem Steuerpad (32) auf der zweiten Hauptfläche;
einen ersten Clip (20; 121);
einen zweiten Clip (21; 120);
einen dritten Clip (22; 122); und
ein Gehäuse (9), in das der Träger, die erste und die zweite elektronische Leistungsvorrichtung sowie teilweise der erste, der zweite und der dritte Clip eingebettet sind, wobei die erste elektronische Leistungsvorrichtung (28.1; 128.1) das erste Leitpad (30), das elektrisch mit dem ersten Clip (20; 121) gekoppelt ist; das zweite Leitpad (31), das elektrisch mit dem dritten Clip (22; 122) gekoppelt ist, und das Steuerpad (32) aufweist, das mit dem ersten Steuerkontaktbereich (36B; 136C) gekoppelt ist;
die zweite elektronische Leistungsvorrichtung (28.2; 128.2) das erste Leitpad (30), das elektrisch mit dem dritten Clip (22; 122) gekoppelt ist, das zweite Leitpad (31), das elektrisch mit dem zweiten Clip (21; 120) gekoppelt ist, und das Steuerpad (32) aufweist, das mit dem zweiten Steuerkontaktbereich (36C; 136B) gekoppelt ist;
die erste und die zweite elektronische Leistungsvorrichtung eine Halbbrückenschaltung (1) bilden; wobei der erste und der zweite Clip (20, 21; 121, 120) jeweils Leistungsstifte (15, 16) bilden, die von einer ersten Seite (5A) des Gehäuses (9) vorstehen, und der dritte Clip (22; 122) einen jeweiligen Leistungsstift (17) aufweist, der von einer zweiten Seite (5B) des Gehäuses (9), gegenüber der ersten Seite (5A) vorsteht;
der erste und der zweite Clip (20, 21; 121; 120) durch Metallbänder ausgebildet sind, die jeweils Hauptausdehnungsflächen aufweisen,
**dadurch gekennzeichnet, dass** sich die Hauptausdehnungsflächen des ersten und des zweiten Clips (20, 21; 121; 120) an gegenüberliegenden Abschnitten (20C, 21C, 20D, 21D, 15, 16), die von dem Gehäuse (9) elektrisch voneinander isoliert sind, überlagern,
wobei die gegenüberliegenden Abschnitte Teile der Leistungsstifte (15, 16) des ersten und des zweiten Clips enthalten, und
wobei das Gehäuse einen vorstehenden Abschnitt (9A) aufweist, der die gegenüberliegenden Abschnitte der Leistungsstifte (15, 16) des ersten und des zweiten Clips (20, 21; 121; 120) umschließt, die von der ersten Seite (5A) des Gehäuses (9) vorstehen, wobei sich das Gehäuse (9) auch zwischen den gegenüberliegenden Abschnitten des ersten und des zweiten Clips (20, 21; 121; 120) erstreckt.

2. Leistungsmodul nach dem vorhergehenden Anspruch, wobei die erste elektronische Leistungsvorrichtung (28.1; 128.1) in Bezug auf die zweite elektronische Leistungsvorrichtung (28.2; 128.2) um eine Trägermittelachse (A), die sich zwischen der ersten und der zweiten elektronischen Leistungsvorrichtung erstreckt, gekippt ist.

3. Leistungsmodul nach Anspruch 1 oder 2, ferner umfassend eine dritte elektronische Leistungsvorrichtung (28.3; 128.3) und eine vierte elektronische Leistungsvorrichtung (28.4; 128.4),
wobei die dritte elektronische Leistungsvorrichtung (28.3; 128.3) eine erste Hauptfläche und eine zweite Hauptfläche, ein erstes Leitpad (30) auf der ersten Hauptfläche, ein zweites Leitpad (31) auf der zweiten Hauptfläche und ein Steuerpad (32) auf der zweiten Hauptfläche aufweist;
wobei die vierte elektronische Leistungsvorrichtung (28.4; 128.4) eine erste Hauptfläche und eine zweite Hauptfläche, ein erstes Leitpad (30) auf der ersten Hauptfläche, ein zweites Leitpad (31) auf der zweiten Hauptfläche und ein Steuerpad (32) auf der zweiten Hauptfläche aufweist;
wobei die dritte elektronische Leistungsvorrichtung (28.3; 128.3) das zweite Leitpad (31), das elektrisch mit dem dritten Clip (22; 122) gekoppelt ist, das erste Leitpad (30), das elektrisch mit dem ersten Clip (20; 121) gekoppelt ist, und das Steuerpad aufweist, das mit dem ersten Steuerkontaktbereich (36B; 136C) gekoppelt ist;
wobei die vierte elektronische Leistungsvorrichtung (28.4; 128.4) das erste Leitpad (30), das elektrisch mit dem dritten Clip (22; 122) gekoppelt ist, das zweite Leitpad (31), das elektrisch mit dem zweiten Clip (21; 120) gekoppelt ist, und das Steuerpad (32) aufweist, das mit dem zweiten Steuerkontaktbereich (36C; 136B) gekoppelt ist.

4. Leistungsmodul nach dem vorhergehenden Anspruch, wenn von Anspruch 2 abhängig, wobei die dritte elektronische Leistungsvorrichtung (28.3; 128.3) in Bezug auf die vierte elektronische Leistungsvorrichtung (28.4; 128.4) um die Trägermittelachse (A) gekippt ist.

5. Leistungsmodul nach einem der vorhergehenden Ansprüche, ferner umfassend einen elektrischen Metallleiter (38), der das Steuerpad (32) der zweiten elektronischen Leistungsvorrichtung (28.2) mit dem zweiten Steuerkontaktbereich (36C) koppelt.

6. Leistungsmodul nach einem der Ansprüche 1 bis 4, ferner umfassend einen elektrischen Metallleiter (38), der das Steuerpad (32) der ersten elektronischen Leistungsvorrichtung (128.1) mit dem ersten Steuerkontaktbereich (136C) koppelt.

7. Leistungsmodul nach einem der vorhergehenden Ansprüche, wobei die gegenüberliegenden Abschnitte (20C, 21C, 20D, 21D, 15, 16) kapazitive Elemente bilden.

8. Leistungsmodul nach einem der vorhergehenden Ansprüche, das ferner Folgendes umfasst:
ein erstes Gate-Verbindungselement (25.2), das mit dem ersten Steuerkontaktbereich (36B) gekoppelt ist; und
ein zweites Gate-Verbindungselement (25.7), das mit dem zweiten Steuerkontaktbereich (36C) gekoppelt ist;
wobei sich das erste und das zweite Gare-Verbindungselemente (25.2, 25.7) quer zu einer Hauptfläche des Trägers (35) erstrecken und einen jeweiligen Endabschnitt (25B) aufweisen, der aus einer Hauptfläche (6) des Gehäuses (9) herausragt.

9. Leistungsmodul nach dem vorhergehenden Anspruch, wobei sich die erste und die zweite Seite des Gehäuses quer zur Hauptfläche (6) des Gehäuses (9) erstrecken.

10. Leistungsmodul nach einem der vorhergehenden Ansprüche, ferner umfassend einen Phasenkontaktbereich (36A), der sich über den Träger (35) erstreckt und elektrisch mit dem dritten Clip gekoppelt ist;
wobei die erste elektronische Leistungsvorrichtung (28.1) die zweite Hauptfläche aufweist, die dem Träger zugewandt ist, und das zweite Leitpad (31), das elektrisch mit dem Phasenkontaktbereich gekoppelt ist;
die zweite elektronische Leistungsvorrichtung (28.2) die erste Hauptfläche aufweist, die dem Träger zugewandt ist, wobei das erste Leitpad (30) elektrisch mit dem Phasenkontaktbereich gekoppelt ist;
der erste Clip (20) die erste Hauptfläche der ersten elektronischen Leistungsvorrichtung (28.1) überlappt und mit dem ersten Leitpad (30) der ersten elektronischen Leistungsvorrichtung gekoppelt ist, und
der zweite Clip (21) die zweite Hauptfläche der zweiten elektronischen Leistungsvorrichtung (28.2) überlappt und mit dem zweiten Leitpad (31) der zweiten elektronischen Leistungsvorrichtung gekoppelt ist.

11. Leistungsmodul nach einem der Ansprüche 1 bis 9, ferner umfassend:
einen ersten Leitkontaktbereich (136A) auf dem Träger (35), der elektrisch mit dem ersten Clip (121) gekoppelt ist;
und
einen zweiten Leitkontaktbereich (136B) auf dem Träger (35), der elektrisch mit dem zweiten Clip (120) gekoppelt ist;
wobei die erste elektronische Leistungsvorrichtung (128.1) die erste Hauptfläche aufweist, die dem Träger zugewandt ist, und das erste Leitpad (30) elektrisch mit dem ersten Leitkontaktbereich (136A) gekoppelt ist;
die zweite elektronische Leistungsvorrichtung (128.2) die zweite Hauptfläche aufweist, die dem Träger (35) zugewandt ist, und das zweite Leitpad (31) elektrisch mit dem zweiten Leitkontaktbereich (136B) gekoppelt ist;
der dritte Clip (122) der zweiten Hauptfläche der ersten elektronischen Leistungsvorrichtung (128.1) und der ersten Hauptfläche der zweiten elektronischen Leistungsvorrichtung (128.2) zugewandt ist und mit dem zweiten Leitpad (31) der ersten elektronischen Leistungsvorrichtung und mit dem ersten Leitpad (30) der zweiten elektronischen Leistungsvorrichtung (128.2) gekoppelt ist.

12. Leistungsmodul nach einem der vorhergehenden Ansprüche, wenn von Anspruch 10 abhängig, ferner umfassend:
ein erstes Hilfsverbindungselement (25.1), das durch einen ersten Hilfskontaktbereich (36D) auf dem Träger (35) mit dem ersten Clip (20) gekoppelt ist;
ein zweites Hilfsverbindungselement (25.8), das durch einen zweiten Hilfskontaktbereich (36E) auf dem Träger (35) mit dem zweiten Clip (21) gekoppelt ist; und
ein drittes Hilfsverbindungselement (25.3, 25.6), das durch den Phasenkontaktbereich (36A) auf dem Träger (35) mit dem dritten Clip (22) gekoppelt ist,
wobei sich das erste, das zweite und das dritte Hilfsverbindungselement quer zu dem Träger (35) erstrecken und einen jeweiligen Abschnitt aufweisen, der aus einer Hauptfläche (6) des Gehäuses (9) herausragt.

13. Leistungsmodul nach einem der vorhergehenden Ansprüche, wobei der Träger (35), der erste Steuerkontaktbereich (36B; 136C) und der zweite Steuerkontaktbereich (36C; 136B) Teil eines mehrschichtigen Substrats (27) sind, das eine erste leitfähige Schicht (36) umfasst, die den ersten Steuerkontaktbereich (36B) und den zweiten Steuerkontaktbereich (36C) bildet, eine zweite leitfähige Schicht (8), die ein einer Außenfläche des Leistungsmoduls (2) zugewandtes wärmeabführendes Element bildet, und eine zwischen der ersten und der zweiten leitfähigen Schicht eingelegte Isolierschicht (35), die den Träger (35) bildet.

14. Leistungsmodul nach einem der vorhergehenden Ansprüche, wobei die erste und die zweite elektronische Leistungsvorrichtung (128.1, 128.2) Leistungs-MOSFETs sind.

15. Leistungsmodul nach einem der vorhergehenden Ansprüche, wobei der erste, der zweite und der dritte Clip (20, 21; 121; 120; 22; 122) monolithisch sind.

## Revendications

1. Module de puissance (2) comprenant :
un support (35) ;
une première zone de contact de commande (36B ; 136C) sur le support ;
une deuxième zone de contact de commande (36C ; 136B) sur le support ;
un premier dispositif de puissance électronique (28.1 ; 128.1) ayant une première face principale et une deuxième face principale, une première plage de conduction (30) sur la première face principale, une deuxième plage de conduction (31) sur la deuxième face principale et une plage de commande (32) sur la deuxième face principale ;
un deuxième dispositif de puissance électronique (28.2 ; 128.2) ayant une première face principale et une deuxième face principale, une première plage de conduction (30) sur la première face principale, une deuxième plage de conduction (31) sur la deuxième face principale et une plage de commande (32) sur la deuxième face principale ;
un premier clip (20 ; 121) ;
un deuxième clip (21 ; 120) ;
un troisième clip (22 ; 122) ; et
un boîtier (9) renfermant le support, les premier et deuxième dispositifs de puissance électroniques ainsi que partiellement les premier, deuxième et troisième clips,
dans lequel le premier dispositif de puissance électronique (28.1 ; 128.1) a la première plage de conduction (30) couplée électriquement au premier clip (20 ; 121) ; la deuxième plage de conduction (31) couplée électriquement au troisième clip (22 ; 122) et la plage de commande (32) couplée à la première zone de contact de commande (36B ; 136C) ;
le deuxième dispositif de puissance électronique (28.2 ; 128.2) a la première plage de conduction (30) couplée électriquement au troisième clip (22 ; 122), la deuxième plage de conduction (31) couplée électriquement au deuxième clip (21 ; 120), et la plage de commande (32) couplée à la deuxième zone de contact de commande (36C ; 136B) ;
les premier et deuxième dispositifs de puissance électroniques forment un circuit en demi-pont (1) ;
les premier et deuxième clips (20, 21 ; 121, 120) formant des broches d'alimentation respectives (15, 16), faisant saillie depuis un premier côté (5A) du boîtier (9) et le troisième clip (22 ; 122) comportant une broche d'alimentation respective (17), faisant saillie depuis un deuxième côté (5B) du boîtier (9), à l'opposé du premier côté (5A) ;
les premier et deuxième clips (20, 21 ; 121, 120) sont formés par des bandes métalliques ayant des surfaces d'extension principale respectives,
**caractérisé en ce que** les surfaces d'extension principale des premier et deuxième clips (20, 21 ; 121, 120) sont mutuellement superposées au niveau de parties en regard (20C, 21C, 20D, 21D, 15, 16) qui sont électriquement isolées les unes des autres par le boîtier (9),
les parties en regard comprenant des parties des broches d'alimentation (15, 16) des premier et deuxième clips, et
le boîtier ayant une partie saillante (9A), renfermant les parties en regard des broches d'alimentation (15, 16) des premier et deuxième clips (20, 21 ; 121, 120) faisant saillie depuis le premier côté (5A) du boîtier (9), le boîtier (9) s'étendant aussi entre les parties en regard des premier et deuxième clips (20, 21 ; 121, 120).

2. Module de puissance selon la revendication précédente, dans lequel le premier dispositif de puissance électronique (28.1 ; 128.1) est retourné par rapport au deuxième dispositif de puissance électronique (28.2 ; 128.2) autour d'un axe médian de support (A) s'étendant entre les premier et deuxième dispositifs de puissance électroniques.

3. Module de puissance selon la revendication 1 ou 2, comprenant en outre un troisième dispositif de puissance électronique (28.3 ; 128.3) et un quatrième dispositif de puissance électronique (28.4 ; 128.4),
le troisième dispositif de puissance électronique (28.3 ; 128.3) ayant une première face principale et une deuxième face principale, une première plage de conduction (30) sur la première face principale, une deuxième plage de conduction (31) sur la deuxième face principale et une plage de commande (32) sur la deuxième face principale ;
le quatrième dispositif de puissance électronique (28.4 ; 128.4) ayant une première face principale et une deuxième face principale, une première plage de conduction (30) sur la première face principale, une deuxième plage de conduction (31) sur la deuxième face principale et une plage de commande (32) sur la deuxième face principale ;
le troisième dispositif de puissance électronique (28.3 ; 128.3) ayant la deuxième plage de conduction (31) couplée électriquement au troisième clip (22 ; 122), la première plage de conduction (30) couplée électriquement au premier clip (20 ; 121) et la plage de commande couplée à la première zone de contact de commande (36B ; 136C) ;
le quatrième dispositif de puissance électronique (28.4 ; 128.4) ayant la première plage de conduction (30) couplée électriquement au troisième clip (22 ; 122), la deuxième plage de conduction (31) couplée électriquement au deuxième clip (21 ; 120) et la plage de commande (32) couplée à la deuxième zone de contact de commande (36C ; 136B).

4. Module de puissance selon la revendication précédente lorsqu'elle dépend de la revendication 2, dans lequel le troisième dispositif de puissance électronique (28.3 ; 128.3) est retourné par rapport au quatrième dispositif de puissance électronique (28.4 ; 128.4) autour de l'axe médian de support (A).

5. Module de puissance selon l'une quelconque des revendications précédentes, comprenant en outre un conducteur électrique métallique (38) reliant la plage de commande (32) du deuxième dispositif de puissance électronique (28.2) à la deuxième zone de contact de commande (36C).

6. Module de puissance selon l'une quelconque des revendications 1 à 4, comprenant en outre un conducteur électrique métallique (38) reliant la plage de commande (32) du premier dispositif de puissance électronique (128.1) à la première zone de contact de commande (136C).

7. Module de puissance selon l'une quelconque des revendications précédentes, dans lequel les parties en regard (20C, 21C, 20D, 21D, 15, 16) forment des éléments capacitifs.

8. Module de puissance selon l'une quelconque des revendications précédentes, comprenant en outre :
un premier élément de connexion de grille (25.2) couplé à la première zone de contact de commande (36B) ; et
un deuxième élément de connexion de grille (25.7) couplé à la deuxième zone de contact de commande (36C) ;
les premier et deuxième éléments de connexion de grille (25.2, 25.7) s'étendant transversalement par rapport à une face principale du support (35) et ayant une partie d'extrémité respective (25B) faisant saillie depuis une surface principale (6) du boîtier (9).

9. Module de puissance selon la revendication précédente, dans lequel les premier et deuxième côtés du boîtier s'étendent transversalement par rapport à la surface principale (6) du boîtier (9).

10. Module de puissance selon l'une quelconque des revendications précédentes, comprenant en outre une zone de contact de phase (36A) s'étendant sur le support (35) et couplée électriquement au troisième clip ;
dans lequel le premier dispositif de puissance électronique (28.1) a la deuxième face principale orientée vers le support et la deuxième plage de conduction (31) couplée électriquement à la zone de contact de phase ;
le deuxième dispositif de puissance électronique (28.2) a la première face principale orientée vers le support, la première plage de conduction (30) couplée électriquement à la zone de contact de phase ;
le premier clip (20) chevauche la première face principale du premier dispositif de puissance électronique (28.1) et est couplé à la première plage de conduction (30) du premier dispositif de puissance électronique, et
le deuxième clip (21) chevauche la deuxième face principale du deuxième dispositif de puissance électronique (28.2) et est couplé à la deuxième plage de conduction (31) du deuxième dispositif de puissance électronique.

11. Module de puissance selon l'une quelconque des revendications 1 à 9, comprenant en outre :
une première zone de contact de conduction (136A) sur le support (35) couplée électriquement au premier clip (121) ; et
une deuxième zone de contact de conduction (136B) sur le support (35) couplée électriquement au deuxième clip (120) ;
dans lequel le premier dispositif de puissance électronique (128.1) a la première face principale orientée vers le support et la première plage de conduction (30) est couplée électriquement à la première zone de contact de conduction (136A) ;
le deuxième dispositif de puissance électronique (128.2) a la deuxième face principale orientée vers le support (35) et la deuxième plage de conduction (31) est couplée électriquement à la deuxième zone de contact de conduction (136B) ;
le troisième clip (122) est en face de la deuxième face principale du premier dispositif de puissance électronique (128.1) et de la première face principale du deuxième dispositif de puissance électronique (128.2) et est couplé à la deuxième plage de conduction (31) du premier dispositif de puissance électronique et à la première plage de conduction (30) du deuxième dispositif de puissance électronique (128.2).

12. Module de puissance selon l'une quelconque des revendications précédentes lorsqu'elle dépend de la revendication 10, comprenant en outre :
un premier élément de connexion auxiliaire (25.1), couplé au premier clip (20) par l'intermédiaire d'une première zone de contact auxiliaire (36D) sur le support (35) ;
un deuxième élément de connexion auxiliaire (25.8), couplé au deuxième clip (21) par l'intermédiaire d'une deuxième zone de contact auxiliaire (36E) sur le support (35) ; et
un troisième élément de connexion auxiliaire (25.3, 25.6), couplé au troisième clip (22) par l'intermédiaire de la zone de contact de phase (36A) sur le support (35),
les premier, deuxième et troisième éléments de connexion auxiliaire s'étendant transversalement par rapport au support (35) et ayant une partie respective faisant saillie depuis une surface principale (6) du boîtier (9).

13. Module de puissance selon l'une quelconque des revendications précédentes, dans lequel le support (35), la première zone de contact de commande (36B ; 136C) et la deuxième zone de contact de commande (36C ; 136B) font partie d'un substrat multicouche (27) comportant une première couche conductrice (36) formant la première zone de contact de commande (36B) et la deuxième zone de contact de commande (36C), une deuxième couche conductrice (8) formant un élément de dissipation thermique faisant face à une surface extérieure du module de puissance (2) et une couche isolante (35) intercalée entre les première et deuxième couches conductrices et formant le support (35).

14. Module de puissance selon l'une quelconque des revendications précédentes, dans lequel les premier et deuxième dispositifs de puissance électroniques (128.1, 128.2) sont des transistors MOSFET de puissance.

15. Module de puissance selon l'une quelconque des revendications précédentes, dans lequel les premier, deuxième et troisième clips (20, 21 ; 121 ; 120 ; 22 ; 122) sont monolithiques.
